Europäisches Patentamt

European Patent Office

Office européen des brevets

(19)

(11) Publication number: **0 136 097 B1**

## EUROPEAN PATENT SPECIFICATION

(12)

(45) Date of publication of patent specification: **16.12.92**  (51) Int. Cl.5: **H01S 3/19, H01L 33/00**

(21) Application number: **84305876.9**

(22) Date of filing: **29.08.84**

(54) **Method for the production of semiconductor lasers.**

(30) Priority: **30.08.83 JP 160681/83**

(43) Date of publication of application:
**03.04.85 Bulletin 85/14**

(45) Publication of the grant of the patent:
**16.12.92 Bulletin 92/51**

(84) Designated Contracting States:
**DE GB NL**

(56) References cited:
**EP-A- 0 058 231**
**US-A- 4 149 175**
**US-A- 4 347 611**

**PATENT ABSTRACTS OF JAPAN, vol. 7, no.
154 (E-185)[1299], 6th July 1983; & JP-A-58 64
085 (NIPPON DENKI K.K.) 16-04-1983**

**PATENT ABSTRACTS OF JAPAN, vol. 6, no.
136 (E-120)[1014], 23th July 1982; & JP-A-57
62 586 (NIPPON DENKI K.K.) 15-04-1982**

(73) Proprietor: **SHARP KABUSHIKI KAISHA
22-22 Nagaike-cho Abeno-ku
Osaka 545(JP)**

(72) Inventor: **Hayakawa, Toshiro
17-402 Katsuragi-cho
Nara-shi Nara-ken(JP)**
Inventor: **Miyauchi, Nobuyuki
2613-1 Ichinomoto-cho
Tenri-shi Nara-ken(JP)**
Inventor: **Yano, Seiki
126-80 Toyoto-cho
Kashihara-shi Nara-ken(JP)**
Inventor: **Suyama, Takahiro
2613-1 Ichinomoto-cho
Tenri-shi Nara-ken(JP)**

(74) Representative: **Kosmin, Gerald Emmanuel et
al
HASELTINE, LAKE & CO. Hazlitt House 28
Southampton Buildings Chancery Lane
London, WC2A 1AT(GB)**

EP 0 136 097 B1

# Description

This invention relates to a method for the production of semiconductor lasers having a structure, which is effective to control a transverse mode of laser oscillation, by the use of a crystal growth technique for the formation of thin films such as molecular beam epitaxy or metal-organic chemical vapor deposition.

Recently, a single crystal growth technique for the formation of thin films such as molecular beam epitaxy (MBE), metal-organic chemical vapor deposition (MO-CVD), etc. has been developed which enables the formation of thin film growth layers having a thickness of as thin as approximately $10^{-6}$ mm (10 Å). The development of such a technique, although these significantly thin films have not yet been produced by liquid phase epitaxy (LPE), allowed the thin films to be applied to lasers, resulting in laser devices exhibiting new laser effects and/or superior laser characteristics. A typical example of these new laser devices is a quantum well (QW) laser, which is produced based on the fact that quantization levels are established in its active layer by reducing the thickness of the active layer to approximately $10^{-5}$ mm (100 Å) or less and which is advantageous over conventional double heterostructure lasers in that the threshold current level is low and the temperature and transient characteristics are superior. Such a quantum well laser is described in detail in the following papers:

(1) W.T.Tsang, Applied Physics Letters, vol.39, No.10 pp.786 (1981),

(2) N.K.Dutta,
Journal of Applied Physics, vol.53, No.11, pp. 7211 (1982), and

(3) H. Iwamura, T. Saku, T. Ishibashi, K. Otuka, Y. Horikoshi, Electronics Letters, vol.19, No.5, pp.180 (1983).

As mentioned above, the single crystal growth technique, such as molecular beam epitaxy or metal-organic chemical vapor deposition, has resulted in the practical use of high quality semiconductor lasers having a new multiple-layered structure. However, the semiconductor laser is deficient in that a stabilized transverse mode of laser oscillation cannot be attained due to its multiple-layered structure.

One of the most important points requiring improvement in other conventional semiconductor lasers which are in practical use, is stabilization of the transverse mode of the laser oscillation. A contact stripe geometric laser, which was developed in the early stage of laser development, has a striped electrode to prevent electric current injected from transversely expanding, and attains a laser oscillation in a zero order mode (i.e., a fundamental transverse mode) upon exceeding the threshold current level, due to gains required for the laser oscilation are greater than losses within the active region underneath the stripe region, while the said contact stripe geometric laser produces a laser oscillation in an expanded transverse mode or a higher-order transverse mode with an increase in the injection of current beyond the threshold current level, because carriers which are injected into the active layer spread to the outside of the striped region resulting in expanding the high gain region. Due to such an unstable transverse mode and dependency of the transverse mode upon the amount of injected electric current, the linear relationship between the injected electric current and the laser output decreases. Moreover, the laser output resulting from pulse modulation is unstable so that the signal-noise ratio is reduced and its directivity becomes too unstable to be used in an optical system such as optical fibers, etc. In order to overcome the above-mentioned practical drawbacks of contact stripe geometric lasers, a variety of structures for semiconductor lasers of GaAlAs and/or InGaAsP systems have been already produced by liquid phase epitaxy, which prevent not only electric current but also a light from transversely expanding thereby attaining stabilization in the transverse mode. However, most of these semiconductor lasers can only be produced by the growth of thin film layers on a grooved substrate, a mesa substrate or a terraced substrate based on a peculiarity of the liquid phase epitaxy, typical examples of which are channel-substrate planar structure injection lasers (CSP lasers) (K. Aiki, M. Nakamura, T. Kuroda and J. Umeda, Applied Physics Letters, vol.30, No.12, pp.649 (1977)-), constricted double heterojunction lasers (CDH lasers) (D. Botez, Applied Physics Letters, vol.33, pp.872 (1978)) and terraced substrate lasers (TS lasers) (T. Sugino, M. Wada, H. Shimizu, K. Itoh, and I. Teramoto, Applied Physics Letters, vol.34, No.4, (1979)). All of these lasers can be only produced utilizing anisotrophy of the crystal growth rate, but not produced by the use of a crystal growth technique such as molecular beam epitaxy (MBE) or metal-organic chemical vapor deposition (MO-CVD).

Patent Abstracts of Japan, vol. 7, No. 154, (E-185) (1299) July 6, 1983 (& JP-A-58 64085) discloses a process for manufacturing a heterostructure semiconductor laser, in which process a mesa is formed using a photoresist strip as a mask for etching the substrate. After the mesa is formed, the mask is removed. Material for forming a blocking layer is deposited directly onto the substrate, by liquid phase epitaxy. No material is deposited on top of the mesa. Further layers (e.g. cladding and active layers) are all formed by liquid phase epitaxy.

EP-A-0 058 231 discloses a process for manufacturing a heterostructure semiconductor laser, which process relies upon liquid phase epitaxy. In the process, after the mesa is formed, material is deposited directly on the substrate, by liquid phase epitaxy. The material deposited on top of the mesa (either a single layer or two layers together) is thinner than material deposited on the substrate surface surrounding the mesa, as a result of the use of liquid phase epitaxy. After deposition, material is removed (by re-absorption into a melt solution) to the extent all the material deposited on the mesa disappears so that the top of the mesa is exposed. Some material remains on the substrate surrounding the mesa and this remaining material provides a current blocking effect. Further layers (e.g. cladding and active layers) are also all formed by liquid phase epitaxy.

Patent Abstracts of Japan, vol. 6, No. 136, (E-120) (1014) July 23, 1982 (& JP-A-57 62586) discloses a process for manufacturing a heterostructure semiconductor laser, in which process a projected stripe (a mesa) is formed, then blocking layers are grown on both sides of the mesa, and then etch-back is performed to recess the mesa below the top of the layers (i.e. the mesa is etched). Thereafter, further layers (e.g. cladding and active layers) are grown. Then the further layers are etched so that they remain only above the mesa (i.e. those layers are "mesa striped"). Then another layer is grown to enclose the mesa stripe, i.e. to enclose the further layers.

US-A-4 149 175 discloses a process for manufacturing a heterostructure semiconductor laser. In the process, mesas are formed on a substrate using stripes of $SiO_2$ as a mask for substrate etching. Recesses between the mesas are then filled with resistive material, so that the top faces of the material are flush with the top faces of the mesas. The stripes remain in place on the mesas during the recess-filling process. The resistive material is said to be grown by a vapour phase growth method by thermal decomposition. Resistive material is not deposited on top of the mesas as the recesses are filled. After deposition of the resistive material the top faces of the resistive material and the mesas are lapped to form a mirror-like flush face. Thereafter, further layers are formed on the flush face by sequential epitaxial growths. These further layers are flat.

US-A-4 347 611 discloses a process for manufacturing a heterostructure semiconductor laser. The laser structures formed by the process do not include blocking layers. The laser structures may be formed by liquid phase epitaxy. One structure is said to be formed by molecular beam or metalorganic chemical vapour deposition.

According to the present invention there is provided a method for the production of a heterostructure semiconductor laser, including forming a substrate with a striped film thereon, and etching the substrate to provide a striped portion formed into a mesa with the striped film on top of the mesa,

characterized in that the method comprises:-

depositing material for forming a current blocking layer on the striped film on top of the mesa, and on the remaining face of the substrate around the mesa, such that the material deposited on the remaining face of the substrate is single crystalline in form and is of a thickness greater than the height of the mesa,

eliminating the deposited material from the striped film together with the striped film, by etching whereby the current blocking layer is provided on the remaining face of the substrate and the striped portion affords a groove,

successively laminating crystal growth layers for laser operation on the whole face of the substrate, by depositions which form the growth layers in strict conformity, such as is obtainable with molecular beam epitaxy or metal-organic chemical vapor deposition, with the groove.

The semiconductor growth layers include, in a preferred embodiment, one selected from GaAlAs, InGaP, InGaAlP, InAlAs, InGaAs and InGaAsP systems.

The semiconductor layers are, in a preferred embodiment, grown by molecular beam epitaxy or metal-organic chemical vapor deposition.

Thus, the invention described herein makes possible the objects of (**1**) providing a method for the production of semiconductor lasers having a stabilized transverse mode and (**2**) providing a method for the production of the above-mentioned semiconductor lasers by molecular beam epitaxy or metal-organic chemical vapor deposition.

For a better understanding of the invention and to show how the same may be carried into effect, reference will now be made, by way of example, to the accompanying drawings in which:

Figures **1** to **5**, respectively, are diagrammatical sectional views showing the production process of a semiconductor laser, for assistance in explanation of this invention;

Figure **6** is a sectional view showing an active layer having a quantum-well heterostructure of another semiconductor laser, for assistance in explanation of this invention; and

Figure **7** is a sectional view showing a semiconductor laser according to this invention.

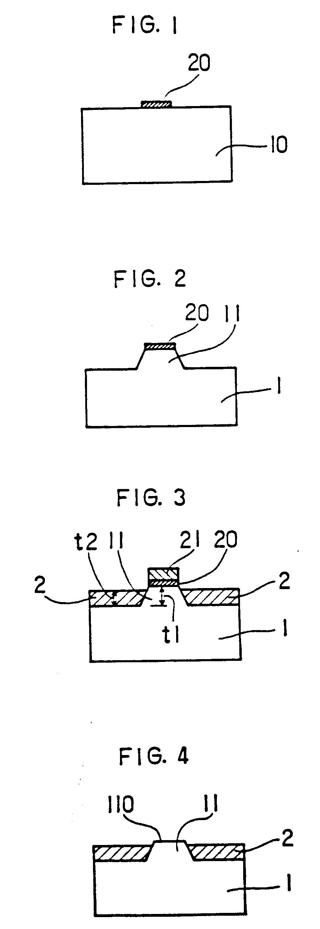

As shown in Figure **1**, a striped $Si_3N_4$ film is formed on a p-GaAs substrate 10 by a photolithography method. Then, the remaining portion of the substrate **10** which has not been masked by the

striped $Si_3N_4$ film **20** is mesa-etched by a well known etching technique, as shown in Figure **2**, resulting in a substrate **1** having a striped portion formed into a mesa **11**, on the top of which the striped $Si_3N_4$ film **20** remains. On the mesa substrate **1** having the $Si_3N_4$ film **20** thereon, n-GaAs current blocking layers **2** and **21** are grown by molecular beam epitaxy, as shown in Figure **3**, in such a manner that the thickness $t_2$ of the n-GaAs layer **2** is smaller than the height $t_1$ of the mesa portion **11**. The thickness of the said layers can be easily controlled using a molecular beam epitaxy method. The n-GaAs layer **21**, which is grown on the $Si_3N_4$ film **20** concurrently with the n-GaAs layer **2** on the substrate **1**, except the mesa portion **11**, does not crystallize in a single crystal structure but crystallizes in a polycrystal structure.

Then, using an etchant such as hydrochloric acid, the $Si_3N_4$ film **20** is removed together with the n-GaAs layer **21** thereon resulting in the n-GaAs layer **2** alone remaining on the substrate **1** as shown in Figure **4**. In this etching process, selective etching can be carried out if a proper etchant is employed. Since $t_1$ is greater than $t_2$, the mesa portion **11** of the substrate **1** forms in a terrace **110** structure even though the n-GaAs layer **2** remains on the substrate **1**.

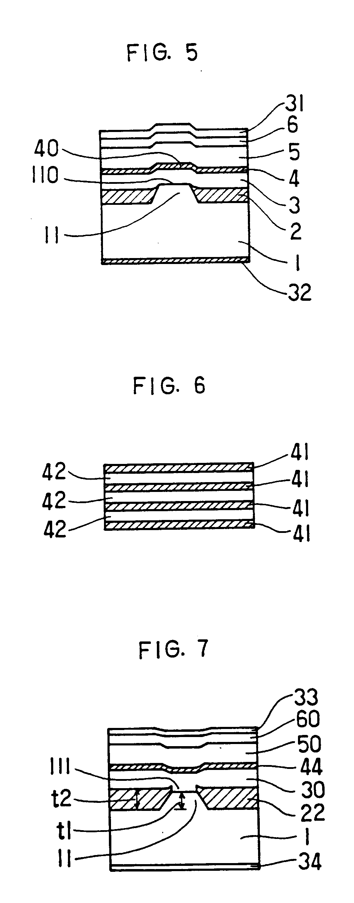

Then, on the substrate **1** shown in Figure **4**, a p-$Ga_{0.7}Al_{0.3}$As cladding layer **3** (the thickness thereof being **1** $\mu$m), a non-doped GaAs active layer **4** (the thickness thereof being **0.08** $\mu$m), a n-$Ga_{0.7}Al_{0.3}$As cladding layer **5** (the thickness thereof being **1** $\mu$m) and a n-GaAs cap layer **6** (the thickness thereof being **0.5** $\mu$m) are successively formed by a molecular beam epitaxy, followed by the formation of a n-type electrode **31** and a p-type electrode **32** on the surface of the n-GaAs cap layer **6** and the back face of the substrate **1** by an evaporation process, respectively, resulting in a semiconductor laser as shown in Figure **5**.

Using molecular beam epitaxy, as described above, each of the growth layers successively formed on the substrate **1** having a terrace **110** shown in Figure **4** consequently conforms to the terraced form of the substrate **1** as seen from Figure **5**. The resulting active layer **4**, which is constricted at both sides of the region therein corresponding to the terrace **110** of the substrate **1**, forms a striped region **40**, serving as a light waveguide to stabilize the transverse mode of the laser oscillation. The light waveguide in the active layer **4** is adjusted in position to the stripe into which an electric current is injected, while the injected electric current is blocked by the n-GaAs current blocking layer **2** and flows through the mesa portion **11** alone of the substrate **1**. Thus, the semiconductor laser results in a structure which is superior to the stabilization of the transverse mode.

As shown in Figure **6**, as an active layer, a quantum-well heterostructure consisting of, for example, a combination of plural non-doped GaAs well layers 41 (the thickness of each layer being $10^{-5}$ mm (100 Å) and plural non-doped $Ga_{0.8}Al_{0.2}$As barrier layers 42 (the thickness of each layer being $3 \times 10^{-6}$ mm (30 Å)) can be used, instead of the non-doped GaAs active layer **4** shown in Figure **5**, thereby obtaining a semiconductor laser exhibiting a quantum-well effect and a stabilized transverse mode.

In an embodiment of the present invention, as shown in Figure **7**, an n-GaAs current blocking layer **22** is grown on the substrate **1** in such a manner that a thickness $t_2$ of the n-GaAs layer **22** is greater than a height $t_1$ of the mesa portion **11** of the substrate **1**, in contrast to the afore-mentioned example, resulting in the formation of a groove **111** on the face of the substrate **1**. By the use of molecular beam epitaxy in the same manner as in the afore-mentioned example, growth layers such as a p-$Ga_{0.7}Al_{0.3}$As cladding layer 30, a non-doped GaAs active layer **44**, a non-$Ga_{0.7}Al_{0.3}$As cladding layer **50** and a n-GaAs cap layer **60** can be successively formed on the whole face of the substrate **1** in strict conformity with the grooved form of the substrate **1**, producing a light waveguide in the active layer **44**. Then, an n-type electrode **33** and a p-type electrode **34** are likewise formed on the n-GaAs cap layer **6** and the back face of the substrate **1**, respectively.

Although only GaAlAs-semiconductor lasers produced using molecular beam epitaxy were described above they can be also produced using metal-organic chemical vapor deposition or other crystal growth techniques in such a manner that the growth layers conform to a grooved form of the face of the substrate. This invention is also applicable to other semiconductor lasers of InGaP, InGaAlP, InAlAs, InGaAs or InGaAsP systems, or the like, in addition to the GaAlAs system.

**Claims**

1.  A method for the production of a heterostructure semiconductor laser, including forming a substrate (1) with a striped film (20) thereon, and etching the substrate (1) to provide a striped portion formed into a mesa (11) with the striped film (20) on top of the mesa (11),

    characterized in that the method comprises:-

    depositing material (21, 2) for forming a current blocking layer on the striped film (20) on top of the mesa (11), and on the remaining face of the substrate around the mesa, such that the material (2) deposited on the remaining face of the substrate is single crystalline in form and is of a thickness greater than the height of the mesa,

eliminating the deposited material (21) from the striped film (20) together with, the striped film (20), by etching whereby the current blocking layer (2) is provided on the remaining face of the substrate and the striped portion affords a groove (111),

successively laminating crystal growth layers (3, 4, 5, 6) for laser operation on the whole face of the substrate, by depositions which form the growth layers (3, 4, 5, 6) in strict conformity, such as is obtainable with molecular beam epitaxy or metal-organic chemical vapor deposition, with the groove (111).

2. A method according to claim 1, wherein said growth layers include one selected from the GaAlAs, InGaP, InGaAlP, InAlAs, InGaAs and InGaAsP systems.

3. A method according to claim 1 or 2, wherein said growth layers are grown by molecular beam epitaxy or metal-organic chemical vapor deposition.

**Patentansprüche**

1. Verfahren zur Herstellung eines Heterostruktur-Halbleiterlasers, welches Verfahren die Bildung eines Substrats (1) mit einer Streifenschicht (20) darauf und die Ätzung des Substrats (1) beinhaltet, um einen Streifenbereich in einer Mesa (11) zu bilden, wobei sich die Streifenschicht (20) auf der Oberseite der Mesa (11) befindet,

**dadurch gekennzeichnet**, daß das Verfahren aufweist:

Ablagern von Material (21, 2) zur Bildung einer Stromsperrschicht auf der auf der Oberseite der Mesa (11) befindlichen Streifenschicht (20) und auf der übrigen Oberfläche des Substrats um die Mesa, so daß das auf der übrigen Oberfläche des Substrats abgelagerte Material (2) einkristalline Form und eine Dicke, die größer als die Höhe der Mesa, aufweist,

Entfernen des abgelagerten Materials (21) von der Streifenschicht (20) zusammen mit der Streifenschicht (20) durch Ätzung, wodurch die Stromsperrschicht (2) auf der übrigen Fläche des Substrats erhalten wird und der Streifenbereich eine Einsenkung (111) bildet,

aufeinanderfolgendes Beschichten mit aufgewachsenen Kristallschichten (3, 4, 5, 6) zum Laserbetrieb auf der gesamten Oberfläche des Substrats, durch Ablagerungen, die die aufgewachsenen Schichten (3, 4, 5, 6) in genauer Anpassung, wie sie durch Molekularstrahlepitaxie oder metallorganische Gasphasenabscheidung erreichbar ist, an die Einsenkung (111) bilden.

2. Verfahren nach Anspruch 1, wobei die aufgewachsenen Halbleiterschichten wahlweise eines von den GaAlAs-, InGaP-, InGaAlP-, InAlAs-, InGaAs- und InGaAsP-Systemen enthält.

3. Verfahren nach Anspruch 1 oder 2, wobei die aufgewachsenen Schichten durch Molekularstrahlepitaxie oder metallorganische Gasphasenabscheidung gezüchtet sind.

**Revendications**

1. Procédé de production d'un laser à semiconducteur à hétérostructure, consistant à former un substrat (1) comportant sur lui un film en bande (20) et à attaquer le substrat (1) de façon à réaliser une partie en bande en forme d'un mésa (11) sur le dessus duquel se trouve le film en bande (20),

caractérisé en ce qu'il consiste :

à déposer une matière (21, 2) pour former une couche de blocage de courant sur le film en bande (20) se trouvant sur le dessus du mésa (11), et sur la face restante du substrat se trouvant autour du mésa, de façon telle que la matière (2) déposée sur cette face restante du substrat soit sous une forme cristalline unique et soit d'une épaisseur supérieure à la hauteur du mésa,

à éliminer du film en bande (20) la matière déposée (21), et en même temps ce film en bande (20), par attaque, de sorte que la couche de blocage de courant (2) est réalisée sur la face restante du substrat et que la partie en bande constitue une rainure (111), et

à déposer, successivement et de manière stratifiée, des couches de croissance de cristal (3, 4, 5, 6), destinées au fonctionnement du laser, sur toute la face du substrat, au moyen de dépôts qui forment les couches de croissance (3, 4, 5, 6) suivant une stricte conformité, telle que ce qui peut être obtenu par épitaxie par faisceau moléculaire ou par dépôt chimique en phase vapeur d'un organo-métallique, avec la rainure (111).

2. Procédé suivant la revendication 1, selon lequel les couches de croissance sont en un système choisi parmi les systèmes GaAlAs, InGaP, InGaAlP, InAlAs, InGaAs et InGaAsP.

3. Procédé suivant la revendication 1 ou 2, selon lequel on fait croître les couches de croissance par épitaxie par faisceau moléculaire ou par dépôt chimique en phase vapeur d'un organo-métallique.

FIG. 1

FIG. 2

FIG. 3

FIG. 4

FIG. 5

FIG. 6

FIG. 7